(19) Europäisches Patentamt

European Patent Office

Office européen des brevets

(11) EP 0 869 548 A1

(12) **EUROPEAN PATENT APPLICATION**

(43) Date of publication:
07.10.1998 Bulletin 1998/41

(51) Int. Cl.$^6$: **H01L 21/60**, H01L 23/485, H01L 21/56

(21) Application number: 98105868.8

(22) Date of filing: 31.03.1998

(84) Designated Contracting States:
AT BE CH DE DK ES FI FR GB GR IE IT LI LU MC NL PT SE
Designated Extension States:
AL LT LV MK RO SI

(30) Priority: 31.03.1997 JP 79720/97

(71) Applicant: NEC CORPORATION
Tokyo (JP)

(72) Inventors:
• Suzuki, Kouichi
Minato-ku, Tokyo (JP)
• Sato, Sadanobu
Minato-ku, Tokyo (JP)
• Yamashita, Yumiko
Minato-ku, Tokyo (JP)

(74) Representative:
von Samson-Himmelstjerna, Friedrich R., Dipl.-Phys. et al
SAMSON & PARTNER
Widenmayerstrasse 5
80538 München (DE)

(54) **Resin-sealed wireless bonded semiconductor device**

(57) A bonding structure of a semiconductor chip to a substrate comprises both a bonding portion including at least an aluminum-containing electrode formed on the semiconductor chip and a gold-containing electrically conductive bump on the aluminum-containing electrode, wherein the bonding portion further includes Pd and Cu.

FIG. 2

**Description**

The present invention relates to a semiconductor device, and more particularly to a resin-sealed and wireless bonded semiconductor device, wherein a semiconductor chip is bonded onto an insulation substrate through conductive pads.

Generally, the semiconductor device has a semiconductor chip and a package for sealing the semiconductor device. Particularly in the filed such as the multi-media for dealing with a large amount of informations, the high density of the integration of the semiconductor device and the scaling down of the device are required. Such requirements will be on the increase in future. In order to respond to those requirements, the progress in scaling down of the semiconductor device is remarkable.

Such the high density integrated and scaled down semiconductor devices have a large number of electrodes for electrical connection to external devices. The electrodes are usually made of aluminum. On the other hands, the package for the semiconductor chip has a mounting substrate on which a semiconductor chip is mounted and lead frames for electrical connections to the aluminum electrodes of the semiconductor chip.

The semiconductor chip is first mounted on the mounting substrate for electrical connection through conductive lines to the lead frames. The resin sealed packaging method for the resin sealing of the semiconductor chip and parts of the lead frame and conducive lines can be used widely as being suitable for mass production.

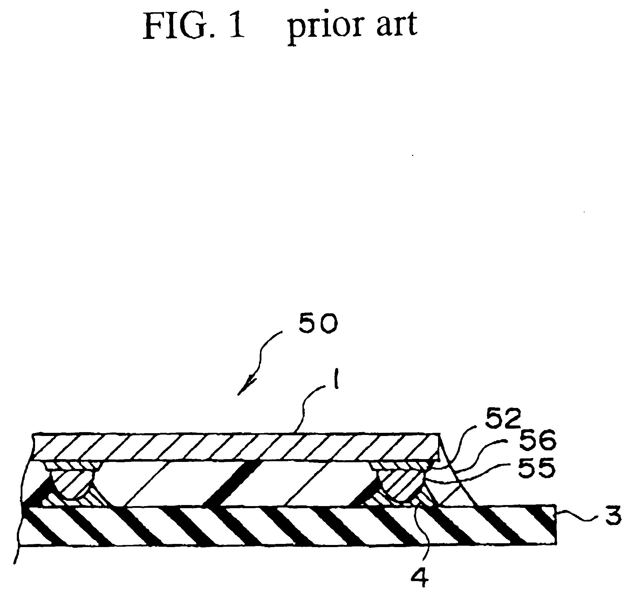

FIG. 1 is a fragmentary cross sectional elevation view illustrative of a conventional resin sealed wireless semiconductor device. A semiconductor chip 1 has a bottom surface on which aluminum electrode pads 52 are formed. Conductive bumps 55 are bonded with the aluminum electrode pads 52 so that the conductive bumps 55 are bonded in face down with a substrate 3 by use of an alloy solder 4 for subsequent resin sealing thereof. Gold bumps are usually used as conductive bumps 55 to be connected to the aluminum pads 52 on the semiconductor chip 1. Gold has a large spreading property. This means that the gold bump is unlikely to be disconnected even a stress is applied when the resin is filled. Gold is also most inactive and highly resistive to corrosion due to impurity and moisture in the resin. Gold is further resistive to oxidation in atmosphere.

The above wireless semiconductor device has the following disadvantage in formation of an alloy layer between the aluminum electrode pads of the semiconductor device and the gold bumps for electrical connection to the aluminum pads due to an internally generated heat or a high temperature atmosphere. This alloy layer weakens the bonding strength in a short time. Further, when the high temperature test is carried out for a long time, Kirkendall voids as crack are formed in the aluminum electrode. As a result, the resin sealed semiconductor device has a disadvantage in remarkable deterioration of connection.

In the field for dealing with a large amount of informations in a short time such as multi-media, the semiconductor device is required to be improved in high density integration and high sped performance, for which reason a heat generation from a chip is larger than the traditional ones.

In the traditional semiconductor chips, a junction temperature is not higher than 100°C. The traditional semiconductor chips are required to be operable at a temperature of not higher than 125°C even in special field. A sealing package such as ceramic package is used for a large scale integrated circuit which has a large power consumption in specific field. A heat sink is necessary in those case of the large power consumption to prevent an excess rising of a junction temperature of the semiconductor chip.

The ceramic packaged semiconductor device is somewhat expensive because the fabrication processes are complicated. It is difficult to replace the ceramic package semiconductor device with the resin sealed semiconductor device in view of the mass productivity and the cost performance. If the heat sink is provided in the resin sealed semiconductor device to prevent an excess junction temperature increase, then the fabrication processes are complicated whereby such the semiconductor device is inferiors in the mass productivity and the cost performance.

It has been required that the resin sealed semiconductor device has a heat resistively to a high junction temperature of over 125°C for allowing the mass production of a high speed and high density integrated large scale integrated circuit which generate a large heat and is used in the multi-media.

If the semiconductor device is required to have a heat resistivity to the 150°C junction temperature, then the bonding strength between the gold bumps and aluminum pads is deteriorated. If the junction temperature is maintained over 150°C for a long time, then an alloy layer is grown at the bonding between the aluminum electrode pads and the gold bumps. Such the alloy layer deteriorates the bonding strength between the aluminum electrode pad and the gold wire whereby the gold bump might be removed from the aluminum pads.

The probability of removal of the gold bump from the aluminum electrode pad depends upon a glass transition temperature of the sealing resin. If the glass transition temperature of the used resin is not higher than 150°C, the provability of the gold bump from the aluminum electrode pad is high. If, however, the glass transition temperature of the used resin is about 200°C, then the provability of the gold bump from the aluminum electrode pad is low.

The resin having a high glass transition temperature has a low Young's module and is hard but poor flexibility, for which reason such the resin is unsuitable for packaging the semiconductor chip on the substrate. If the resin absorbs a moisture and heated for soldering process, then the moisture in the resin is rapidly vaporized whereby the crack is likely to be generated in the resin.

In practical use, enabling the device to be operable at a junction temperature of not less than 125°C, it is required to carry out an acceleration life-time test as the reliability test at a high temperature of 125°C, particularly in the range of 175-200°C. For efficient and reliable acceleration life-time text, it preferable to carry out the life-time text at a higher temperature by 50 °C than the practically required junction temperature.

In Japanese laid-open patent publication No. 2-91944, it is disclosed to use a gold bump containing Pd at 0.5-15% for facilitation of process of the gold bump. It is also disclosed to use the gold bump containing at 0.0001-0.2 % by weight at least one of La, Ce and Cs. In Japanese laid-open patent publication No. 2-91944, it is disclosed to use noble metal bumps such as gold bump for connection with the aluminum interconnection pattern on the insulation substrate for bonding the semiconductor device to the insulation substrate, whereby an inter-metallic compound of $Au_4Al$ is formed between the gold bump and the aluminum interconnection.

In the above prior arts, the gold bump or the gold bump and the aluminum interconnection formed on the insulation substrate are considered. Those publications are, however, silent on the problems about the bonding structure between the gold bump and the semiconductor chip as well as the wireless semiconductor device having such the bonding structure. It was difficult to presume the relationship between the stress due to the resin and the fracture strength to the gold bump.

In the above circumstances, it had been required to develop a novel semiconductor device and a novel method of forming the same free from the above disadvantages and problems.

Accordingly, it is an object of the present invention to provide a novel bonding structure to a semiconductor chip for ensuring a sufficiently high thermal resistivity under continuous operation conditions.

It is a further object of the present invention to provide a semiconductor chip having a bonding structure for ensuring a sufficiently high thermal resistivity under continuous operation conditions.

It is a still further object of the present invention to provide a novel semiconductor device capable of preventing crack formation of resin when the semiconductor device is mounted on the printed board.

It is yet a further object of the present invention to provide a novel semiconductor device capable of lowering a cumulative failure probability.

It is a further more object of the present invention to provide a novel method of forming a semiconductor chip for ensuring a sufficiently high thermal resistivity under continuous operation conditions.

It is still more object of the present invention to provide a novel method of forming a semiconductor chip having a bonding structure for ensuring a sufficiently high thermal resistivity under continuous operation conditions.

It is moreover object of the present invention to provide a novel method of forming a semiconductor device capable of preventing crack formation of resin when the semiconductor device is mounted on the printed board.

It is another object of the present invention to provide a novel method of forming a semiconductor device capable of lowering a cumulative failure probability.

It is still another object of the present invention to provide a novel resin-sealed semiconductor device free from the above disadvantages and problems.

It is yet another object of the present invention to provide a novel method of forming a resin-sealed semiconductor device free from the above disadvantages and problems.

It is further another object of the present invention to provide a hybrid semiconductor device with a semiconductor chip free from the above disadvantages and problems.

It is an additional object of the present invention to provide a hybrid semiconductor device with a semiconductor chip free from the above disadvantages and problems.

It is a still additional object of the present invention to provide a resin sealed hybrid semiconductor device sealed with resin.

It is yet an additional object of the present invention to provide a novel method of forming a hybrid semiconductor device with a semiconductor chip free from the above disadvantages and problems.

It is a further additional object of the present invention to provide a novel method of forming a hybrid semiconductor device with a semiconductor chip free from the above disadvantages and problems.

It is also additional object of the present invention to provide a novel method of forming a resin sealed hybrid semiconductor device sealed with resin.

The above and other objects, features and advantages of the present invention will be apparent from the following descriptions.

In accordance with the present invention, a bonding structure of a semiconductor chip to a substrate comprises both a bonding portion including at least an aluminum-containing electrode formed on the semiconductor chip and a gold-containing electrically conductive bump on the aluminum-containing electrode, wherein the bonding portion further includes Pd and Cu.

Preferred embodiments according to the present invention will be described in detail with reference to the accompanying drawings.

FIG. 1 is a fragmentary cross sectional elevation view illustrative of a conventional resin sealed wireless semiconductor device.

FIG. 2 is a fragmentary cross sectional elevation view illustrative of a wireless semiconductor device.

FIGS. 3A and 3B are fragmentary cross sectional elevation views illustrative of a mechanism of removal of the conductive bump from the aluminum-containing electrode pad.

FIG. 4 is a diagram illustrative of an accumulative failure rate over glass transition temperature Tg.

FIG. 5 is a diagram illustrative of variations of accumulative failure rates over time under a high temperature condition, wherein Al/Si pads are used.

FIG. 6 is a diagram illustrative of variations of accumulative failure rates over time under a high temperature condition, wherein Al/Si/Cu pads are used.

FIG. 7 is a diagram illustrative of variations of accumulative failure rates over time under a high temperature condition, wherein Al/Si/Cu pads are used.

In accordance with the present invention, a bonding structure of a semiconductor chip to a substrate comprises both a bonding portion including at least an aluminum-containing electrode formed on the semiconductor chip and a gold-containing electrically conductive bump on the aluminum-containing electrode, wherein the bonding portion further includes Pd and Cu.

It is preferable that the bonding portion may include an alloy layer disposed between the aluminum-containing electrode pad and the gold-containing electrically conductive bump.

It is also preferable that at least any one of the aluminum-containing electrode pad and the gold-containing electrically conductive bump may include Pd. Pd may be included at least any one of surface and inner regions of the one of the aluminum-containing electrode pad and the gold-containing electrically conductive bump.

It is furthermore preferable that the aluminum-containing electrode comprises Cu at 0.1-1% and aluminum at substantially the remaining percentage, whilst the gold-containing electrically conductive bump comprises Pd at 0.5-5% and gold at substantially the remaining percentage and further preferable that the bonding portion has an alloy layer.

In accordance with the further present invention, a semiconductor device is provided which comprises a semiconductor chip, a bonding portion including an aluminum-containing electrode formed on the semiconductor chip and a gold-containing electrically conductive bump on the aluminum-containing electrode, wherein the bonding portion further includes Pd and Cu.

It is also preferable that at least any one of the aluminum-containing electrode pad and the gold-containing electrically conductive bump may include Pd. Pd may be included at least any one of surface and inner regions of the one of the aluminum-containing electrode pad and the gold-containing electrically conductive bump.

It is furthermore preferable that the aluminum-containing electrode comprises Cu at 0.1-1% and aluminum at substantially the remaining percentage, whilst the gold-containing electrically conductive bump comprises Pd at 0.5-5% and gold at substantially the remaining percentage and further preferable that the bonding portion has an alloy layer.

It is possible to extend a high temperature operable life-time of the above semiconductor chip in a junction temperature range of 100-200°C by controlling individual amounts in addition of Pd and Cu.

A hybrid semiconductor device is provided which has a plurality of semiconductor chips with the above novel bonding structure.

In accordance with the furthermore present invention, provision is made for a method of forming a bonding structure of a semiconductor chip to a substrate comprises both a bonding portion including at least an aluminum-containing electrode formed on the semiconductor chip and a gold-containing electrically conductive bump on the aluminum-containing electrode, wherein the bonding portion further includes Pd and Cu.

It is preferable that the bonding portion may include an alloy layer disposed between the aluminum-containing electrode pad and the gold-containing electrically conductive bump.

It is also preferable that at least any one of the aluminum-containing electrode pad and the gold-containing electrically conductive bump may include Pd.

It is furthermore preferable that the aluminum-containing electrode comprises Cu at 0.1-1% and aluminum at substantially the remaining percentage, whilst the gold-containing electrically conductive bump comprises Pd at 0.5-5% and gold at substantially the remaining percentage and further preferable that the bonding portion has an alloy layer.

Prior to formation of he bonding portion, a Pd film may have be formed on a surface of the aluminum-containing electrode. It is preferable that the Pd film may be formed by an electric plating method, an electroless plating method, an evaporation method and a sputtering method.

It is possible to extend a high temperature operable life-time of the above semiconductor chip in a junction temperature range of 100-200°C by controlling individual amounts in addition of Pd and Cu.

A wireless hybrid semiconductor device is provided which has a plurality of semiconductor chips with the above novel bonding structure.

In accordance with the present invention, a resin sealed semiconductor device is provided wherein the above semiconductor device is sealed with a sealing resin.

A resin sealed hybrid semiconductor device is provided wherein a plurality of the above semiconductor devices are sealed with a sealing resin.

A method of forming a resin sealed semiconductor device is provided which includes a process of sealing the semiconductor device with a sealing resin. A glass transition temperature of the sealing resin is controlled to prevent fracture of the resin and deterioration of moisture property du to thermal variation in packaging process.

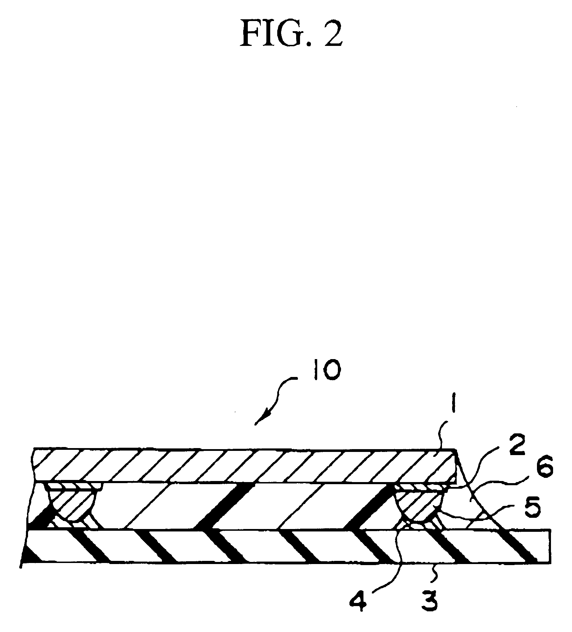

A preferred embodiment in accordance with the present invention will be described, wherein a wireless semiconductor device is provided. FIG. 2 is a fragmentary cross sectional elevation view illustrative of a wireless semiconductor device. A semiconductor chip 1 has a bottom surface on which electrode pads of a conductive material including aluminum are formed. An insulation substrate 3 has a top surface on which a conductive pattern is formed. Conductive bumps 5 are provided for bonding the electrode pads 2 to the substrate. The conductive bumps 5 are fixed on the substrate 3 by a solder 4.

An insulative resin 6 is filled into a space between the semiconductor chip 1 and the substrate 3.

The electrode pads 2 may be made of a conductive material such as a pure aluminum, a silicon-doped aluminum, a silicon and copper-doped aluminum, and a copper doped aluminum.

The conductive bump 5 may be made of a pure gold for a high density semiconductor chip. Notwithstanding, a gold-copper alloy bump and a 1% Pd-containing gold bump are available. Th gold bump 5 is bonded to the aluminum-containing electrode pad 2 and also bonded to the substrate 3. The substrate 3 may comprise a printed board, or may have lead frames for electrical contacts. The semiconductor chip 1 and the conductive bump 5 are sealed with a molten resin. Alternatively, a solder may be re flowed to seal the semiconductor device onto the insulative substrate 3 or the printed board.

It is preferable that such the wireless semiconductor device has a resistivity to the solder reflow and is superior in connection reliability between the conductive bump 5 and the aluminum-containing electrode pad 2 at high temperature. The improvements of the resin and the gold bump are required for high connection reliability. It is required to standardize the connection reliability between the conductive pad 5 and the aluminum-containing electrode pad 2 in operation of the resin sealed semiconductor device at high temperature.

As a factor of an operable temperature limit of the resin sealed wireless semiconductor device, a junction temperature $Tj$ between the conductive pad 5 and the aluminum-containing electrode pad 2 is available.

Assuming that the wireless semiconductor device is put under the conditions of an atmospheric temperature of $Ta(°C)$, a heat resistivity $Rth(°C/W)$ of the wireless semiconductor device, and a power $P0$ to be supplied to the wireless semiconductor device, the junction temperature $Tj$ is given by the following equation.

$$Tj = Ta + Rth \times P0.$$

The heat resistivity of the entire parts of the wireless semiconductor device can be given as the sum of the thermal resistivity $Rth(j-c)$ between the semiconductor chip 1 and the resin 6 and the other thermal resistivity $Rth(c-a)$ between the sealing resin 6 and the external atmosphere. If the high connection reliability between the conductive bump 5 and the aluminum-containing electrode pad 2 is ensured at a junction temperature in the range of 125-150°C, then this means that the wireless semiconductor device has an extremely higher connection reliability than the conventional ones. Particularly, the high speed semiconductor device has a large power consumption, for which reason setting the junction temperature $Tj$ in the range of 125-150°C is extremely important.

From the above equation, it can be understood that in order to set the junction temperature $Tj$ in the range of 125-150°C, the heat resistivity of the entire of the package is set at about 20°C/W under an atmospheric temperature of 100°C and a power $P0$ of 1W. It is also confirmed that the connection reliability of the junction portion of the wireless semiconductor device in operation is presumable and can be ensured for a long time, if the connection reliability is ensured at the above junction temperature for over 1000 hours.

It is possible that the resin of a higher glass transition temperature than the conventional ones is used and a selected composition of the gold bump is used for obtaining the junction temperature in the range of 125-150°C.

An amount of silica included in the sealing resin for sealing the semiconductor chip 1 is so set that the glass transition temperature $Tg$ of the sealing resin is in the range of 140-160°C. In this case, the resin having a glass transition temperature lower than 140°C has a quality for over 1000 hours at the junction temperature of 120 °C. If the glass transition temperature is beyond 160°C, a crack is generated.

If further the resin 6 having a glass transition temperature in the range of 140-160°C, it is required to consider a relationship to a stress applied to the conductive bump 5 when sealed with the resin.

As a result of an examination, the pure gold bump free of any impurity allows a generation of Kirkendall voids as crack which increases a probability of malfunction when a high temperature storage test is carried out at 150°C. In this case, it is possible to keep the quality of the semiconductor device for 1000 hours. As a result of consideration of the composition of the conductive bump 5 in relation to the above resin 6, it can be confirmed that if gold containing copper or palladium at 1% by weight is used as a bump, the life-time of over 1000 hours at 150°C is ensured a probability of malfunction of the device is remarkable reduced.

If the gold bump containing copper at 1% by weight is used as the bump, copper exists on an interface between the copper-containing gold bump and the aluminum-containing electrode pad 2 whereby the formation of gold-aluminum alloy is delayed in time. Further if the percent by weight of copper contained in the gold bump is increased, the oxidation of copper is promoted so that a copper oxide film is formed at the point of the gold bump. This formation of the copper oxide film makes it difficult to bond the semiconductor chip onto the substrate. It is preferable that the gold bump includes copper in the range of 0.5-5.0% by weight. It is also preferable that the gold bump includes palladium in the range of 0.5-5.0% by weight.

A difference in life-time between different materials was investigated by the present inventor for individuals of the conductive bump 5 and the aluminum-containing electrode pad 2. The following Table 1 shows the results of the investigations.

TABLE 1

| conductive bump | Au | Au | Au/Cu | 1%Pd |
|---|---|---|---|---|
| electrode pad | Al/Si | AlSiCu | AlSi | AlSiCu |
| life-time Tj 150°C 10ppm | 553Hr | 1130Hr | 1220Hr | 14200Hr |
| life-time Tj 150°C 10ppm | (2310) | (4710) | (5160) | (59800) |
| rate | 1 | 2 | 2.2 times | 25.7 times |
| conductive bump | Au | 1%Pd | | |
| electrode pad | AlSiCu | AlSiCu | | |
| life-time Tj 150°C 10ppm | 519Hr | >5370Hr | | |
| life-time Tj 150°C 10ppm | (2310) | (4710) | | |
| rate | 1 | >10.3 | | |

As shown in Table 1, the life-time of the bonding structure of the gold bump and the Al/Si/Cu electrode pad is longer by 2 times than the life-time of the bonding structure of the gold bump and the Al/Si electrode pad. The life-time of the bonding structure of the Au/Cu bump and the Al/Si electrode pad is longer by 2.2 times than the life-time of the bonding structure of the gold bump and the Al/Si electrode pad. The life-time of the bonding structure of the 1%Pd containing Au bump and the Al/Si/Cu electrode pad is longer by 25.7 times than the life-time of the bonding structure of the gold bump and the Al/Si electrode pad. The life-time of the bonding structure of the 1%Pd containing Au bump and the Al/Si/Cu electrode pad is longer by 10.3 times than the life-time of the bonding structure of the gold bump and the Al electrode pad.

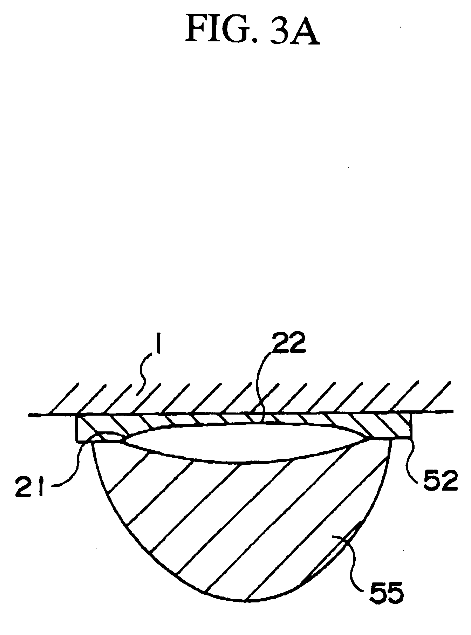

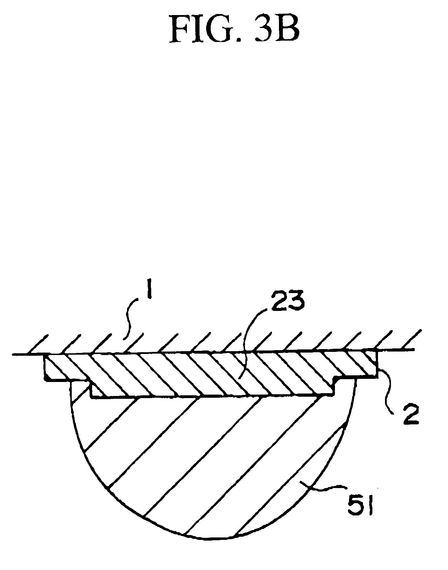

FIGS. 3A and 3B are fragmentary cross sectional elevation views illustrative of a mechanism of removal of the conductive bump from the aluminum-containing electrode pad In FIG. 3A, an alloy layer 21 is formed between the Au conductive bump 5 and the aluminum-containing electrode pad 52. A Kirkendall void 22 as a crack is formed between the alloy layer 21 and the gold bump 55. The Kirkendall void 22 may cause the gold bump to be removed from the alloy layer 21.

By contrast, as illustrated in FIG. 3B, the 1%Pd containing Au bump allows formation of the alloy layer 23 without, however, formation of any Kirkendall void. No Kirkendall void is no cause to remove the bump from the electrode pad, for which reason the 1%Pd containing Au bump allows the bonding structure to have a long life-time.

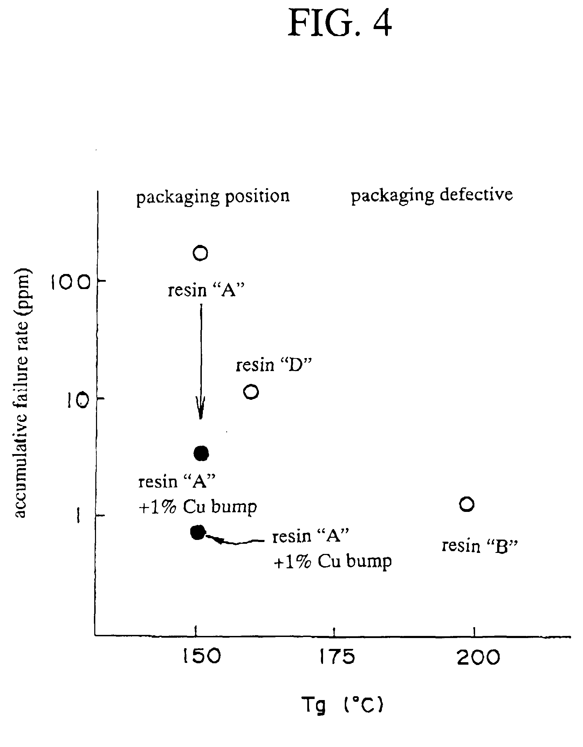

FIG. 4 is a diagram illustrative of an accumulative failure rate over glass transition temperature Tg. If the copper free gold bump is sealed with a resin "A" having a glass transition temperature of 150°C, then the accumulative failure rate is 100 ppm. If, however, 1% by weight copper containing gold bump is sealed with this resin "A", then the accumulative failure rate is less than 10 ppm. If a resin "B" having a glass transition temperature of 200°C is used, the accumulative failure rate is reduced whilst the packageabilty is deteriorated.

The above descriptions have been made when the copper containing gold bump is used. Notwithstanding, if 1.0% by weight palladium containing gold bump is used, the results are the same. If, for example, 1.0% by weight palladium containing gold bump is sealed with the resin "A", then the accumulative failure rate is 0.8 ppm when a test was made at 150°C and for 1000 hours. This means it possible to drop the accumulative failure rate down to a rate lower than when the 1.0% by weight copper containing gold bump is used.

From FIG. 4, it can be understood that if the resin having a glass transition temperature in the range of 140°C through 160°C, then a long life-time of the junction portion at a high temperature condition and a good packageability are also obtainable. If the resin having the glass transition temperature Tg in the range of 140°C through 160°C, then an impurity in the resin is leaked out and evaporated whereby the impurity promotes a reaction to form alloy. The resin having a high glass transition temperature Tg is free from the stress due to variation in temperature in the range over the glass transition temperature, for which reason the life-time of the junction portion under a high temperature condition can be improved.

A difference in life-time between different materials was investigated by the present inventor for individuals of the conductive bump 5, the aluminum-containing electrode pad 2 and the resin 6. The following Table 2 shows the results of the investigations.

TABLE 2

| Sample A: | | | | | |
|---|---|---|---|---|---|
| Resin | Bump | Pad | 150°C | 250°C | activation energy |
| | | | 10ppm life-time (Hr) | | |
| "A" Tg=149°C | Au | Al/Si | 553 | 2310 | 0.84 |
| "D" Tg=160°C | Au | Al/Si | 926 | 3890 | 0.84 |
| "B" Tg=195°C | Au | Al/Si | 1350 | 5770 | 0.84 |
| resin "A" | Au/Cu | Al/Si | 1220 | 5160 | 0.84 |
| Sample B: | | | | | |
| Resin | Bump | Pad | 150°C | 250°C | activation energy |
| | | | 10ppm life-time (Hr) | | |
| "A" Tg=149°C | Au | Al/Si/Cu | 1130 | 4710 | 0.80 |
| "A" Tg=149°C | Au/Pd | Al/Si/Cu | 14200 | 59800 | 0.80 |
| Sample C: | | | | | |
| Resin | Bump | Pad | 150°C | 250°C | activation energy |
| | | | 10ppm life-time (Hr) | | |
| "C" | Au | Al/Si/Cu | 519 | 5280 | 1.2 |
| "C" | Au/Pd | Al/Si/Cu | 5370 | 51900 | 1.2 |

As shown on the Table 3, if the Au bump is replaced by the Au-Pd bump, then the life-time is extended by 12 times. If the Al-containing electrode pad is replaced by the Al-Si-Cu electrode pad, then the life-time is extended by 2 times.

In order to evaluate the reliability of the junction portion, 1% by weight Pd containing gold bump is used to carry out a test under a temperature cycle in the range of 65-150°C. The results of the test are shown on the following Table 3.

TABLE 3

| Product | Test | Sample | Result |
|---|---|---|---|
| "C" | Temperature cycle | Au/Pd | 500 cycles 0/20 |
| "C" | Temperature cycle | Conventional Au | 500 cycles 0/20 |
| "C" | PCT (125°C, 2.3 atm) | Au/Pd | 300 Hr 0/20 |
| "C" | PCT (125°C, 2.3 atm) | Conventional Au | 300 Hr 0/20 |
| "D" | pretreatment+temperature cycle | Au/Pd | 500 cycles 0/20 |
| "D" | pretreatment+temperature cycle | conventional Au | 500 cycles 0/20 |
| "D" | pretreatment+PCT(125°C, 2.3 atm) | Au/Pd | 300 Hr 0/20 |
| "D" | pretreatment+PCT(125°C, 2.3 atm) | conventional Au | 300 Hr 0/20 |

TABLE 3 (continued)

| Product | Test | Sample | Result |
|---|---|---|---|
| "E" | pretreatment+temperature cycle | Au/Pd | 1000 cycles 0/20 |
| "F" | pretreatment+temperature cycle | Au/Pd | 1000 cycles 0/12 |

As shown on Table 3, the Au-Pd bump has a reliability other than the life-time equivalently to the conventional Au bump.

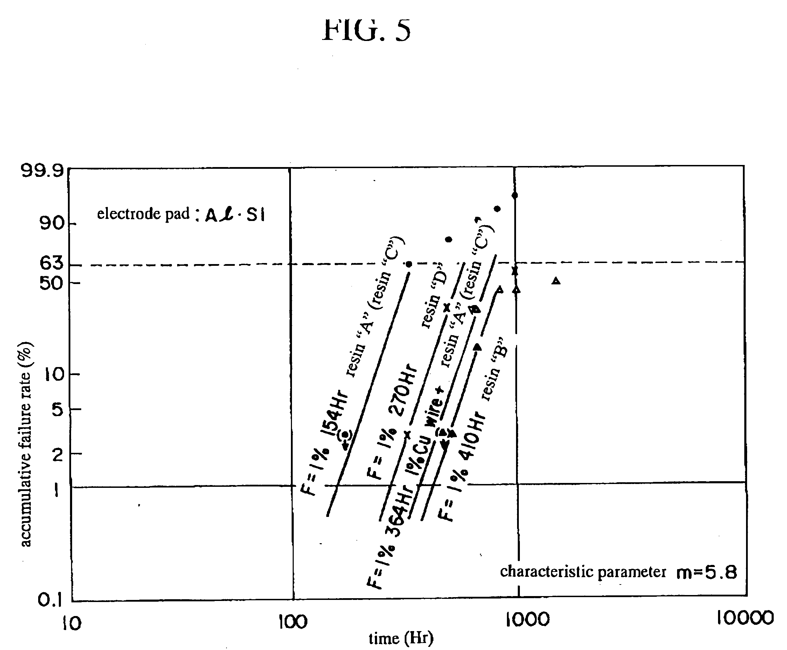

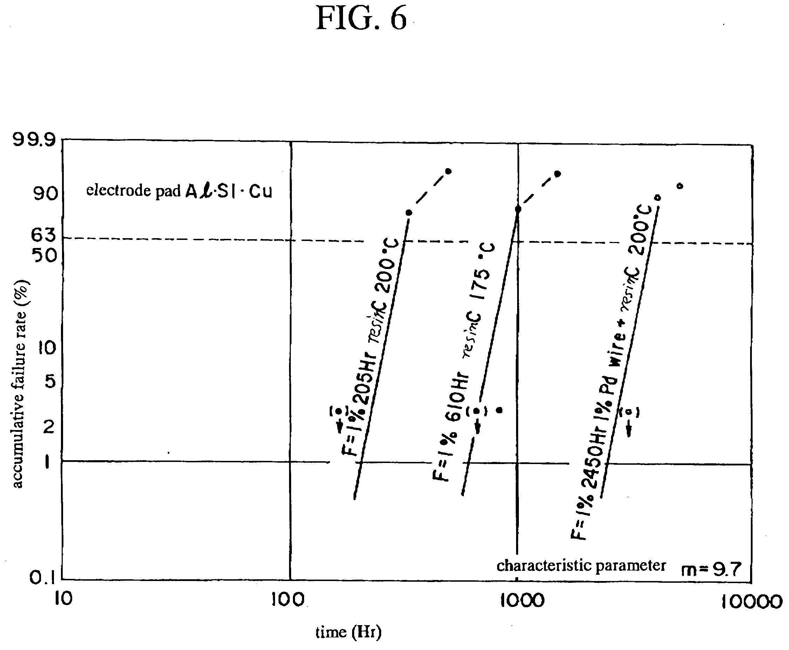

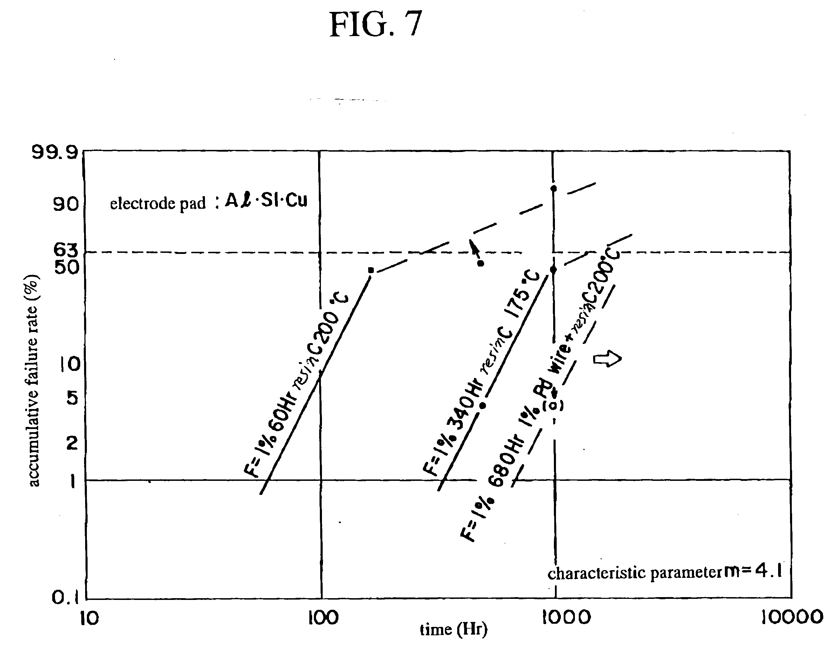

FIG. 5 is a diagram illustrative of variations of accumulative failure rates over time under a high temperature condition, wherein Al/Si pads are used. FIG. 6 is a diagram illustrative of variations of accumulative failure rates over time under a high temperature condition, wherein Al/Si/Cu pads are used. FIG. 7 is a diagram illustrative of variations of accumulative failure rates over time under a high temperature condition, wherein Al/Si/Cu pads are used.

As can be understood, if the Au bump is replaced by the Au/Pd bump, then the life-time is extended by 12 times. If the Au bump is replaced by the Au/Cu bump, then the life-time is extended by 2 times. If the Al/Si electrode pads are replaced by the Al/Si/Cu electrode pads, then the life-time is extended by 2 times.

Whereas modifications of the present invention will be apparent to a person having ordinary skill in the art, to which the invention pertains, it is to be understood that embodiments as shown and described by way of illustrations are by no means intended to be considered in a limiting sense. Accordingly, it is to be intended to cover by claims all modifications which fall within the spirit and scope of the present invention.

**Claims**

1. A bonding structure for bonding a semiconductor chip onto a substrate, said bonding structure comprising a bonding portion including at least an aluminum-containing electrode formed on said semiconductor chip and a gold-containing electrically conductive bump on said aluminum-containing electrode,
   characterized in that said bonding portion further contains at least any one of Pd and Cu.

2. The bonding structure as claimed in claim 1, characterized in that said bonding portion has an alloy layer disposed between said aluminum-containing electrode pad and said gold-containing electrically conductive bump.

3. The bonding structure as claimed in claim 1, characterized in that at least any one of said aluminum-containing electrode pad and said gold-containing electrically conductive bump includes Pd.

4. The bonding structure as claimed in claim 3, characterized in that Pd is included in a surface region of said aluminum-containing electrode pad.

5. The bonding structure as claimed in claim 3, characterized in that Pd is included in an inner region of said aluminum-containing electrode pad and the gold-containing electrically conductive bump.

6. The bonding structure as claimed in claim 3, characterized in that Pd is included in a surface region of said gold-containing electrically conductive bump.

7. The bonding structure as claimed in claim 3, characterized in that Pd is included in an inner region of said gold-containing electrically conductive bump.

8. The bonding structure as claimed in claim 1, characterized in that at least any one of said aluminum-containing electrode pad and said gold-containing electrically conductive bump includes Cu.

9. The bonding structure as claimed in claim 8, characterized in that Cu is included in a surface region of said aluminum-containing electrode pad

10. The bonding structure as claimed in claim 8, characterized in that Cu is included in an inner region of said aluminum-containing electrode pad and the gold-containing electrically conductive bump.

11. The bonding structure as claimed in claim 8, characterized in that Cu is included in a surface region of said gold-containing electrically conductive bump.

12. The bonding structure as claimed in claim 8, characterized in that Cu is included in an inner region of said gold-containing electrically conductive bump.

13. The bonding structure as claimed in claim 1, characterized in that said aluminum-containing electrode comprises Cu at 0.1-1% and aluminum at substantially the remaining percentage, whilst said gold-containing electrically conductive bump comprises Pd at 0.5-5% and gold at substantially the remaining percentage and further characterized in that said bonding portion has an alloy layer.

14. A semiconductor device comprising a semiconductor chip, a bonding portion including an aluminum-containing electrode formed on said semiconductor chip and a gold-containing electrically conductive bump on said aluminum-containing electrode, characterized in that said bonding portion further includes any at least any one of Pd and Cu.

15. The semiconductor device as claimed in claim 14, characterized in that at least any one of said aluminum-containing electrode pad and said gold-containing electrically conductive bump includes Pd.

16. The semiconductor device as claimed in claim 15, characterized in that Pd is included in a surface region of said aluminum-containing electrode pad.

17. The semiconductor device as claimed in claim 15, characterized in that Pd is included in an inner region of said aluminum-containing electrode pad.

18. The semiconductor device as claimed in claim 15, characterized in that Pd is included in a surface region of said gold-containing electrically conductive bump.

19. The semiconductor device as claimed in claim 14, characterized in that Pd is included in an inner region of said gold-containing electrically conductive bump.

20. The semiconductor device as claimed in claim 14, characterized in that at least any one of said aluminum-containing electrode pad and said gold-containing electrically conductive bump includes Cu.

21. The semiconductor device as claimed in claim 20, characterized in that Cu is included in a surface region of said aluminum-containing electrode pad.

22. The semiconductor device as claimed in claim 20, characterized in that Cu is included in an inner region of said aluminum-containing electrode pad.

23. The semiconductor device as claimed in claim 20, characterized in that Cu is included in a surface region of said gold-containing electrically conductive bump.

24. The semiconductor device as claimed in claim 20, characterized in that Cu is included in an inner region of said gold-containing electrically conductive bump.

25. The semiconductor device as claimed in claim 14, characterized in that said aluminum-containing electrode comprises Cu at 0.1-1% and aluminum at substantially the remaining percentage, whilst the gold-containing electrically conductive bump comprises Pd at 0.5-5% and gold at substantially the remaining percentage and further characterized in that the bonding portion has an alloy layer.

26. A wireless hybrid semiconductor device having a plurality of semiconductor chips with a bonding structure for bonding a semiconductor chip onto a substrate, said bonding structure comprising a bonding portion including at least an aluminum-containing electrode formed on said semiconductor chip and a gold-containing electrically conductive bump on said aluminum-containing electrode,
characterized in that said bonding portion further contains at least any one of Pd and Cu.

27. The wireless hybrid semiconductor device as claimed in claim 26, characterized in that said bonding portion has an alloy layer disposed between said aluminum-containing electrode pad and said gold-containing electrically conductive bump.

**28.** The wireless hybrid semiconductor device as claimed in claim 26, characterized in that at least any one of said aluminum-containing electrode pad and said gold-containing electrically conductive bump includes Pd.

**29.** The wireless hybrid semiconductor device as claimed in claim 28, characterized in that Pd is included in a surface region of said aluminum-containing electrode pad.

**30.** The wireless hybrid semiconductor device as claimed in claim 28, characterized in that Pd is included in an inner region of said aluminum-containing electrode pad and the gold-containing electrically conductive bump.

**31.** The wireless hybrid semiconductor device as claimed in claim 28, characterized in that Pd is included in a surface region of said gold-containing electrically conductive bump.

**32.** The wireless hybrid semiconductor device as claimed in claim 28, characterized in that Pd is included in an inner region of said gold-containing electrically conductive bump.

**33.** The wireless hybrid semiconductor device as claimed in claim 26, characterized in that at least any one of said aluminum-containing electrode pad and said gold-containing electrically conductive bump includes Cu.

**34.** The wireless hybrid semiconductor device as claimed in claim 33, characterized in that Cu is included in a surface region of said aluminum-containing electrode pad.

**35.** The wireless hybrid semiconductor device as claimed in claim 33, characterized in that Cu is included in an inner region of said aluminum-containing electrode pad and the gold-containing electrically conductive bump.

**36.** The wireless hybrid semiconductor device as claimed in claim 33, characterized in that Cu is included in a surface region of said gold-containing electrically conductive bump.

**37.** The wireless hybrid semiconductor device as claimed in claim 33, characterized in that Cu is included in an inner region of said gold-containing electrically conductive bump.

**38.** The wireless hybrid semiconductor device as claimed in claim 26, characterized in that said aluminum-containing electrode comprises Cu at 0.1-1% and aluminum at substantially the remaining percentage, whilst said gold-containing electrically conductive bump comprises Pd at 0.5-5% and gold at substantially the remaining percentage and further characterized in that said bonding portion has an alloy layer.

**39.** A resin sealed semiconductor device sealed with a sealing resin and having a bonding structure for bonding a semiconductor chip onto a substrate, said bonding structure comprising a bonding portion including at least an aluminum-containing electrode formed on said semiconductor chip and a gold-containing electrically conductive bump on said aluminum-containing electrode,
characterized in that said bonding portion further contains at least any one of Pd and Cu.

**40.** The resin sealed semiconductor device as claimed in claim 39, characterized in that said bonding portion has an alloy layer disposed between said aluminum-containing electrode pad and said gold-containing electrically conductive bump.

**41.** The resin sealed semiconductor device as claimed in claim 39, characterized in that at least any one of said aluminum-containing electrode pad and said gold-containing electrically conductive bump includes Pd.

**42.** The resin sealed semiconductor device as claimed in claim 41, characterized in that Pd is included in a surface region of said aluminum-containing electrode pad.

**43.** The resin sealed semiconductor device as claimed in claim 41, characterized in that Pd is included in an inner region of said aluminum-containing electrode pad and the gold-containing electrically conductive bump.

**44.** The resin sealed semiconductor device as claimed in claim 41, characterized in that Pd is included in a surface region of said gold-containing electrically conductive bump.

**45.** The resin sealed semiconductor device as claimed in claim 41, characterized in that Pd is included in an inner region of said gold-containing electrically conductive bump.

46. The resin sealed semiconductor device as claimed in claim 39, characterized in that at least any one of said aluminum-containing electrode pad and said gold-containing electrically conductive bump includes Cu.

47. The resin sealed semiconductor device as claimed in claim 46, characterized in that Cu is included in a surface region of said aluminum-containing electrode pad.

48. The resin sealed semiconductor device as claimed in claim 46, characterized in that Cu is included in an inner region of said aluminum-containing electrode pad and the gold-containing electrically conductive bump.

49. The resin sealed semiconductor device as claimed in claim 46, characterized in that Cu is included in a surface region of said gold-containing electrically conductive bump.

50. The resin sealed semiconductor device as claimed in claim 46, characterized in that Cu is included in an inner region of said gold-containing electrically conductive bump.

51. The resin sealed semiconductor device as claimed in claim 39, characterized in that said aluminum-containing electrode comprises Cu at 0.1-1% and aluminum at substantially the remaining percentage, whilst said gold-containing electrically conductive bump comprises Pd at 0.5-5% and gold at substantially the remaining percentage and further characterized in that said bonding portion has an alloy layer.

# FIG. 1   prior art

# FIG. 2

# FIG. 3A

# FIG. 3B

# FIG. 4

packaging position          packaging defective

accumulative failure rate (ppm)

100

resin "A"

10          resin "D"

resin "A"
+1% Cu bump

1          resin "A"          resin "B"
          +1% Cu bump

150          175          200

Tg (°C)

# FIG. 5

EP 0 869 548 A1

# FIG. 6

# FIG. 7

**European Patent Office**

## EUROPEAN SEARCH REPORT

Application Number

EP 98 10 5868

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 013, no. 121 (E-732), 24 March 1989 & JP 63 289947 A (TOSHIBA CORP), 28 November 1988, * abstract * | 1-7, 14-19, 26-32, 39-45 | H01L21/60 H01L23/485 H01L21/56 |
| X | PATENT ABSTRACTS OF JAPAN vol. 015, no. 078 (E-1037), 22 February 1991 & JP 02 296336 A (SEIKO EPSON CORP), 6 December 1990, * abstract * | 1,3-5, 14-17, 26, 28-30, 39,41-43 | |
| X | DE 44 42 960 C (FRAUNHOFER GES FORSCHUNG) 21 December 1995 * column 4, line 49 - column 5, line 5; claim 5; figure 1 * | 1,3,6,7, 14,15, 18,19, 26,28, 31,32, 39,41, 44,45 | |
| A | | 13,21, 38,51 | **TECHNICAL FIELDS SEARCHED** (Int.Cl.6) H01L |
| X | EP 0 313 082 A (TOKYO SHIBAURA ELECTRIC CO) 26 April 1989 * claims 3-7; figure 1D * | 1,3,6, 14,15, 18,26, 28,31, 39,41,44 | |
| X | PATENT ABSTRACTS OF JAPAN vol. 013, no. 068 (E-716), 16 February 1989 & JP 63 252445 A (FUJI ELECTRIC CO LTD), 19 October 1988, * abstract * | 1,3,7, 14,15, 19,26, 28,32, 39,41,45 | |

-/--

The present search report has been drawn up for all claims

| Place of search | Date of completion of the search | Examiner |
|---|---|---|
| BERLIN | 7 July 1998 | Munnix, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

**EP 0 869 548 A1**

| European Patent Office | EUROPEAN SEARCH REPORT | Application Number EP 98 10 5868 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN<br>vol. 013, no. 132 (E-736), 31 March 1989<br>& JP 63 299239 A (TOSHIBA CORP), 6 December 1988,<br><br>* abstract * | 1,8-12,<br>14,<br>20-24,<br>26,<br>33-37,<br>39,46-50 | |
| X | PATENT ABSTRACTS OF JAPAN<br>vol. 013, no. 195 (E-754), 10 May 1989<br>& JP 01 015956 A (NEC CORP), 19 January 1989,<br><br>* abstract * | 1,8,11,<br>14,20,<br>23,26,<br>33,36,<br>39,46,49 | |
| A | EP 0 704 895 A (NIPPON ELECTRIC CO) 3 April 1996<br><br><br>* column 1, line 55 - column 2, line 5 *<br>* column 6, line 53 - line 58 *<br>* column 8, line 50 - line 55 *<br>* column 9, line 14 - line 15 *<br>* column 10, line 18 - line 20 *<br>* figures 2,3 *<br><br>-/-- | 2,8-12,<br>20-24,<br>26,27,<br>33-37,<br>40,46-50 | TECHNICAL FIELDS SEARCHED (Int.Cl.6) |

The present search report has been drawn up for all claims

| Place of search | Date of completion of the search | Examiner |
|---|---|---|
| BERLIN | 7 July 1998 | Munnix, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

**EUROPEAN SEARCH REPORT**

Application Number

EP 98 10 5868

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | JING E ET AL: "RELIABILITY INVESTIGATIONS OF DIFFERENT BUMPING PROCESSES FOR FLIP CHIP AND TAB APPLICATIONS" NINETEENTH IEEE/CPMT INTERNATIONAL ELECTRONICS MANUFACTURING TECHNOLOGY SYMPOSIUM, AUSTIN, OCT. 14 – 16, 1996, no. SYMP. 19, 14 October 1996, INSTITUTE OF ELECTRICAL AND ELECTRONICS ENGINEERS, pages 274-281, XP000704344 * page 274, right-hand column, last paragraph – page 275, left-hand column, paragraph 1 * | 39 | |

TECHNICAL FIELDS SEARCHED (Int.Cl.6)

The present search report has been drawn up for all claims

| Place of search | Date of completion of the search | Examiner |
|---|---|---|
| BERLIN | 7 July 1998 | Munnix, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)